# EUROPEAN PATENT SPECIFICATION

(11) **EP 1 722 275 B1**
(45) Date of publication and mention of the grant of the patent: **27.10.2010**
(21) Application number: 05103879.2
(22) Date of filing: 10.05.2005
(51) Int. Cl.: G03F 7/32

(54) **Method for processing lithographic printing plates**
Verfahren zur Verarbeitung von Flachdruckplatten
Procédé pour le traitement des plaques d'impression lithographique

(43) Date of publication of application: 15.11.2006
(73) Proprietor: Agfa Graphics N.V., 2640 Mortsel (BE)
(72) Inventor: Gries, Willi - Kurt,, 2640 Mortsel (BE); Van Damme, Marc,, 2640 Mortsel (BE); Boxhorn, Mario,, 2640 Mortsel (BE); Meeus, Pascla,, 2640 Mortsel (BE)
(74) Representative: Goedeweeck, Rudi

(56) References cited:
- EP-A- 0 279 630
- EP-A- 0 556 014
- EP-A- 0 639 797
- US-A- 5 670 294
- US-A- 5 731 132

## Description

### FIELD OF THE INVENTION

The present invention relates to a method of making a lithographic printing plate comprising the steps of providing a photopolymer printing plate precursor that is photopolymerizable upon absorption of light in the wavelength range from 300 to 700 nm, exposing said printing plate precursor with light in the range from 300 to 700 nm and processing said exposed precursor with an aqueous alkaline developer comprising a specific surfactant.

### BACKGROUND OF THE INVENTION

It is well known in the prior art to add surfactants to alkaline developing compositions. For example it is known from EP 099 003 and EP 134 407 to use an anionic surfactant in a developer that has a pH of from 8 to 12, wherein the surfactant is added to stabilize the solution at low temperature.

According to EP 366 321 a surfactant is added to prevent overdevelopment of positive working compositions, which surfactant may be non-ionic such as polyoxyethylene lauryl ether or an ethylene oxide/propylene oxide condensate of poly(ethylene) glycol; the latter being prefered since it also prevents soiling deposits being formed on the plate surface when developing radiation sensitive plates in some automatic plate processors using hard water in their plate washing section. The pH of the developer is not given explicitely.

From EP 720 060 it is known to use one or more surfactant to adjust the surface tension and thereby allow a fast wetting of the sensitive layer, in particular when spraying the developer on the plate. Cationic, anionic, betainic and non-ionic surfactants, alone or in combination, are disclosed to be suitable therefore without further specification. EP 720 060 is related to alkaline developers, but the pH is not explicitely disclosed.

Aqueous alkaline developing solutions are known from EP 732 628, that comprise a non-ionic surfactant and at least another surfactant selected from anionic or amphoteric surfactants. Said developing solutions allow a reduced amount of sludge and less foam.

According to EP 992 854 an amphoteric and at least one anionic surfactant are used together with an N-alkoxylated amine in an alkaline aqueous developer concentrate. Said developer concentrate makes a developer possible having a high development capacity and a reduced tendency of forming unwanted depositions on the developed plates and in the processing apparatus. The amphoteric surfactant disclosed in EP 992 854 preferably is an aminoacid, a salt thereof or an alkylamidoalkylbetain and the anionic surfactants preferably are C₂- to C₁₆-alkyl or aryl sulfates. In addition, the concentrate of EP 992 854 can further contain ingredients like non-inonic and cationic surfactants. The addition of N-alkoxylated amines has the tendency to increase the turbidity of the resulting developers. Thus these developers can give increased settlement, which reduces the circulation in the processor. The consequence is a continuous reduction of circulation flow during usage, which finally can end up in a blockage of processors's spray bars. On the other hand most of the settlements remain in the processor and need to be removed at the end using special cleaning agents.

Non-ionic surfactants in general and several classes thereof are disclosed in EP 1 260 867 for developers suitable to develop thermal printing plates. For the developers containing a surfactant taken from such a class are described therein good image forming properties and a high printing durability.

A class of non-ionic surfactants known to be suitable for alkaline developers are mixed polyethyleneoxy/polypropyleneoxy-blockcopolymers, which are disclosed e.g. in EP 555 098 to and EP 556014 to have respectively 20 weight-% ethylene oxide or 30 weight-% ethylene oxide or less in the molecule for a developer that is capable to develop a fine resist pattern; and in US 4,945,030 to enable a developer with a high initial alkali content with little damage to the image.
EP 639 979 discloses a developer for a positive working printing plate precursor which may comprise a variety of non-ionic surfactants, including polyoxyethylene polyoxypropylene surfactants.

The use of non-ionic surfactants having a linear polar polyoxyalkylene moiety and a hydrophobic residue, hereinafter also called "linear non-ionic surfactants" is rather common and is known, for example from EP 1 457 837, wherein the hydrophobic residue may be an unsubstituted or mono-substituted phenyl, naphthyl or higher annealed aromatic carbocycle and wherein the developing solution comprising such a surfactant in addition comprises a branched surfactant and is used for the development of a positive working heat-sensitive plate. Such linear non-ionic surfactants are also disclosed in EP 1 199 606 as ingredients for a developing solution that is useful for a specific photosensitive composition; in US 6,562,555, wherein the linear non-ionic surfactant is used as a coating attack-supressing agent; in EP 1 353 235 to suppress foaming; in EP 1 334 824, US 6,686,126 and US 6,638,687 to achieve e.g. high printing durability and printing quality; in EP 1 253 472 for IR-plate developers that give a sharp and clear image without damage to the image; and in US 6,641,980 and EP 1 288 722, wherein such coumpounds falling under a broadly defined hydrophobicity range are disclosed to enhance printing durability and running performance of the developer.

A linear non-ionic surfactant, having a tri-substituted hydrophobic phenyl substituent, is disclosed in US 6,248,506 to be unfavourable, as it gives large amounts of sinking residues when used in the developers for UV curable photoresists. The disclosed developers are used for the manufacture of printed circuit boards and are free of silicate. Only when combining such surfactants with an anionic surfactant leads to a useful developer.

Although, as set forth above, there have been made many efforts to reduce deposits in the developing apparatus when processing printing plates and to increase the developing solution stability, the known developing solutions for printing plates, in particular for printing plates sensitive for light in the wavelength range from 300 to 700 nm, are still unsatisfactory in this respect, so that there still is a demanding need to find new developer compositions, that further reduce depositions in the developing apparatus and on the processed printing plates, especially during long run processing, and that increase the sedimentation stability of used developers.

The depositions when using a developer according to the prior art are formed from already detached components of the layer, that are unsufficiently dissolved or dispergated and are deposited on the recording material again or are carried into downstream stations (washbath, gumming station) of the developing machine. Already developed recording materials may become useless in this way. It is mainly during development in machines that components of the layer which are contained in the developer in the form of cakes, filaments or pigment residues, are deposited on the printing plates. In addition, such depositions are formed in the developing machine reducing the circulation flow and decreasing the efficiency of processing, whereby the cleaning effort at the end is high and often aggressive cleaning agents have to be used.

### OBJECTS OF THE INVENTION

It is therefore an object of the present invention to provide a method of processing an UV/VIS sensitive printing plate, that leads to less depositions in the developing apparatus and on the processed printing plates, especially during long run processing. A further advantage of the method of the present invention is, that the developers used for this method, have an increased sedimentation stability.

Therefore it is a further target of the present invention, to fmd a developer, which results, when used in the method of the present invention, in a stable process with constant circulation flow in the processor and a low cleaning effort at the end of the process, giving reduced settlements, which easily can be removed with plain water.

Further aspects and advantages of the invention will become apparent from the description hereinafter.

### SUMMARY OF THE INVENTION

The present invention relates to a method of making a lithographic printing plate comprising the steps of providing a photopolymer printing plate precursor that is photopolymerizable upon absorption of laser light in the wavelength range from 300 to 700 nm, exposing said printing plate precursor with light in the range from 300 to 700 nm and processing said exposed precursor with an aqueous alkaline developer comprising a specific surfactant, that surprisingly leads to less depositions and a superior stability of the developer.

### DETAILED DESCRIPTION OF THE INVENTION

The present invention relates to a method of making a lithographic printing plate comprising the steps of providing a photopolymer printing plate precursor that is photopolymerizable upon absorption of laser light in the wavelength range from 300 to 700 nm, exposing said printing plate precursor with light in the range from 300 to 700 nm and processing said exposed precursor with an aqueous alkaline developer, characterized in that the alkaline developer comprises a surfactant of formula (I) 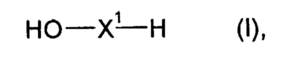 wherein
- X¹: consists of Z¹ and Z² blocks and comprises at least one Z¹ and at least one Z² block,
- Z¹: represents -(-CH₂-CH₂-O-)ₓ- and
- Z²: represents -(-CH₂-CH(CH3)-O-)_{y}-, and wherein
- x, y: mean mutually independent integers and are selected such that the surfactant of formula (I) has a total molecular weight of the Z² block(s) of at least 2000 g/mol, in particular from 2200 to 6000 g/mol and comprises 25 to 55 weight-% of the Z¹ block(s), in particular 30 to 50 weight-% of the Z¹ block(s), wherein the weight-% of the Z1 block(s)
is based on the total molecular weight of the Z¹ blocks and the Z² blocks in the molecule, and a surfactant of Formula IIa, 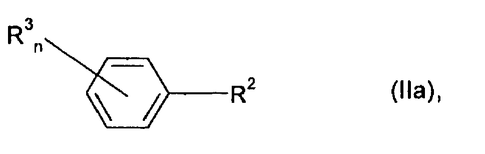 wherein
R² represents a hydrophilic group comprising a polyethyleneoxy group with at least 6 ethyleneoxy units,
R³ represents a 1,1-phenylethyl or a t-butyl group, and
n means 2 or 3.

The alkaline developer used in the method of the present invention is hereinafter also called the developer of the present invention.

The polyoxyethylene blocks Z¹ and the polyoxypropylene blocks Z² can be present in X¹ in any number and arranged in any order, so that X¹ may comprise 1, 2, 3 or more than 3 Z¹ blocks and 1, 2, 3 or more than 3 Z² blocks. If there is more then one Z¹ block and/or more than one Z² block present in the surfactant of formula (I), then the Z¹ blocks and/or the Z² blocks can be the same or different.

In a preferred embodiment of the present invention X¹ means -Z¹-Z²-, -Z²-Z¹-, -Z¹-Z²-Z¹- or -Z²-Z¹-Z²-.

As an example, a surfactant of formula H-O-Z¹-Z²-Z¹-H is a surfactant of formula (I) of the present invention, if x is 25 in every case and y is 50, and therefore the surfactant has a total molecular weight of the Z² block of 2904 g/mol and comprises 43 weight-% of the Z¹ blocks (2203 g/mol with respect to 2203 g/mol + 2904 g/mol).

In the surfactants of the present invention the polyoxyethylene block (hereinafter also called ethyleneoxide block or EO block) represents the hydrophilic moiety and the polyoxypropylene block (hereinafter also called propyleneoxide block or PO block) represents the hydrophobic moiety.

Examples of preferred surfactants of formula (I) are listed in the table below.

| | **Trade Name** | **Mol. Weight of the PO block(s) (g/mol)** | **Weight-% EO** |
|---|---|---|---|
| (I-1) | Pluronic PE 9400^{®} | 2750 | 40 |
| (I-2) | Pluronic PE 10500^{®} | 3250 | 50 |
| (I-3) | Pluronic PE 10400^{®} | 3250 | 40 |
| (I-4) | Pluronic PE 10300^{®} | 3250 | 30 |
| (I-5) | Symperonic T/904^{®} | 4000 | 40 |

The developer of the present invention is based on water and preferably comprises at least one alkaline reacting silicate and has a pH of at least 11. In a preferred embodiment of the present invention, the concentration of the silicate is at least 0.2 weight-% and that of the surfactant of formula (I) at least 0.05 weight-%, in particular at least 0.5 weight-% and most preferable from 1 to 10 weight-%, in each case based on the total weight of the developer. Alkaline developer solutions having a pH range from 11.5 to 14, in particular from 12.0 to 13.5, are preferred.

The above mentioned alkaline reacting silicate shows alkaline properties when dissolved in water. For example, silicates of alkali metals such as sodium silicate, potassium silicate and lithium silicate, and ammonium silicate can be used. Such alkaline reacting silicates may be used alone or in combination.

The developing performance of the alkaline aqueous solution comprising the above mentioned alkaline reacting silicate can be easily controlled by adjusting the mixing ratio of the components constituting the silicate, that is, silicon dioxide (SiO₂) and alkali oxide represented by M₂O, wherein M is an alkali metal or ammonium group, and the concentration of the alkali silicate.

In the above mentioned alkaline aqueous solution, it is preferable that the molar ratio of the alkali oxide (M₂O) to the silicon dioxide (SiO₂) be in the range of 1:0.5 to 1:7.0, from the aspect of moderate alkalinity and developing performance, and more preferably 1:1.0 to 1:5.0.

The concentration of the alkaline reacting silicate in the developing solution is preferably in the range of 0.5 to 10 weight-% from the aspect of developing performance, processing ability and waste fluid treatment, more preferably 1.0 to 8 weight-%, and most preferably 2 to 6 weight-%, with respect to the total weight of the developing solution.

In addition to the metal silicate the developer of the present invention preferably comprises at least one extra inorganic or organic salt having an alkaline reaction in water, that preferably is selected from the group consisting of an alkali metal hydroxide, an alkaline earth metal hydroxide or an ammonium hydroxide, in particular LiOH, KOH or NaOH, or an alkali metal, alkaline earth metal or ammonium salt of an inorganic or organic acid, in particular sodium dihydrogen phosphate or potassium dihydrogen phosphate, disodium hydrogen phosphate or dipotassium hydrogen phosphate, sodium borate, disodium or dipotassium carbonate, sodium or potassium hydrogencarbonate (bicarbonate), sodium or potassium gluconate, an alkali metal salt of an aliphatic, aromatic or araliphatic carboxylic acid, in particular an alkali metal salt of a (C₂-C₁₈)alkanoic acid or of a (C₃₋C₁₈)alkoxyalkanoic acid.

The amount of the extra inorganic or organic salt or salts having an alkaline reaction in water can range from 0 to 15% by weight, preferably from 0 to 8% by weight and most preferred from 0.1 to 6% by weight, based in each case on the total weight of the developer.

In a preferred embodiment of the present invention, the developer not only comprises one surfactant of formula (I), but a combination of at least two different surfactants, that can lead to a synergistic effect. The second, third, fourth, etc. surfactant in such a combination can again be a surfactant of formula (I), but preferably the developer of the present invention comprises at least one surfactant having a structure different to formula (I). The surfactant having a structure different to formula (I) is hereinafter also called extra surfactant or additional surfactant and can be any known surfactant that is not of formula (I).

A surfactant according to the present invention is a substance, which reduces the surface tension, mainly in aqueous systems, and has a characteristic structure containing at least one hydrophilic and one hydrophobic functional group. According to nature and charge of the hydrophilic group surfactants are divided into anionic, nonionic, cationic and amphoteric materials (see Surfactants by K. Koswig in Ullmann's Encyclopedia of Industrial Chemistry, Wiley-VCH 2002, Online Posting Date: June 15, 2000).

Most important anionic surfactants are carboxylates, sulfonates, sulfates, phosphates and phosphonates having a hydrophobic part based on alkyl, alkylaryl, fluoralkyl, silaalkyl, thiaalkyl and oxaalkyl groups.

Usually nonionic surfactants are ethoxylates, which are formally condensation products of hydrophobic alcohols, phenols, mercaptanes, amines, carboxylic acids, carbonamides and others with oligoglycol ethers. Fatty acid esters of glycerol, diglycerol, sugars, hydrogenated sugars such as sorbitol and alkyl(poly)glucosides are also assigned to this class as well as surfactants with semipolar bonded oxygen as hydrophilic group like fatty amine oxides, sulfoxides and phosphine oxides.

Cationic surfactants basically have their cationic structure already present in the molecule as in the case of quaternary ammonium, phosphonium or sulfonium salts. Among them the quaternary nitrogen compound like tetraalkylammonium salts, N,N-dialkylimidazolinium compounds and N-alkylpyridinium salts are the most important.

Amphoteric surfactants are classified as ampholytes, which are compounds having at least on active proton as in the case of aminocarboxylic acids and betaines, which have no mobile protons and are true amphoteric ions containing both cationic and anionic groups.

In addition to this speciality surfactants with heteroatoms in the hydrophobic group can be used. These materials are usually based on fluorocarbons or silicones having hydrophilic groups with anionic, cationic, amphoteric and polyethyleneoxide units.

In the context of the present invention it has been found, that the aforementioned synergistic effect is particularly pronounced, when combining surfactants of formula (I) with surfactants of formula (IIa): 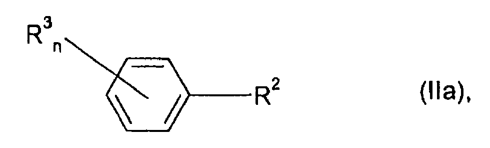 wherein
- R²: represents a hydrophilic group comprising a polyethyleneoxy group with at least 6 ethyleneoxy units,
- R³: represents a 1,1-phenylethyl or a t-butyl group, in particular a 1,1-phenylethyl group, and
- n: means 2 or 3, in particular 3.

Particular preferred surfactants of formula (IIa) are given by the following examples:

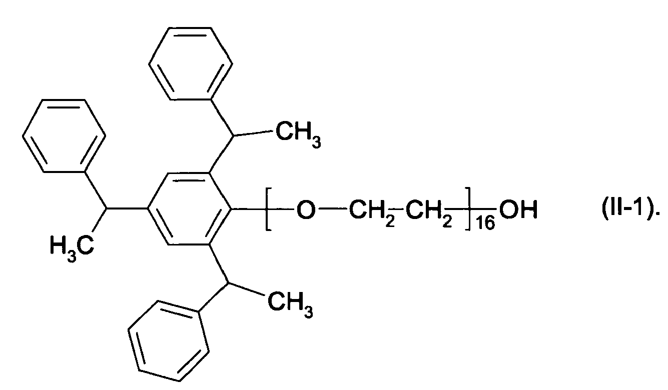

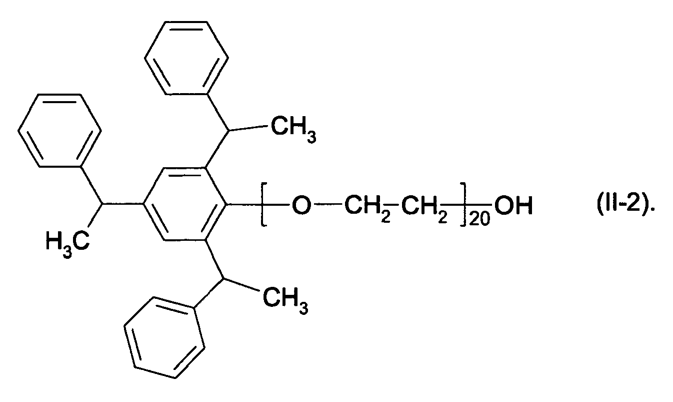

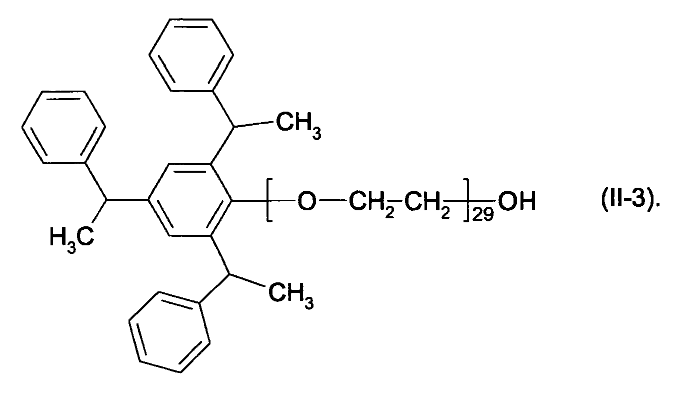

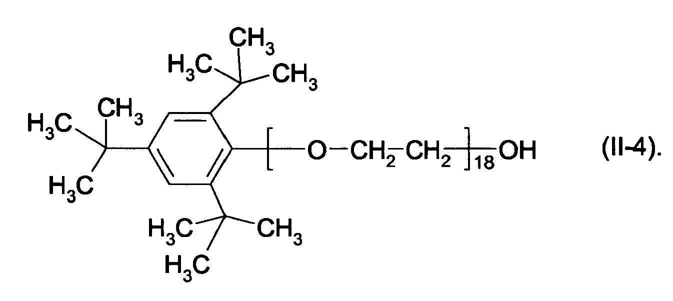

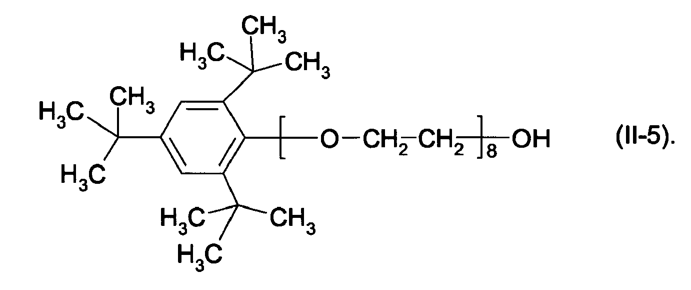

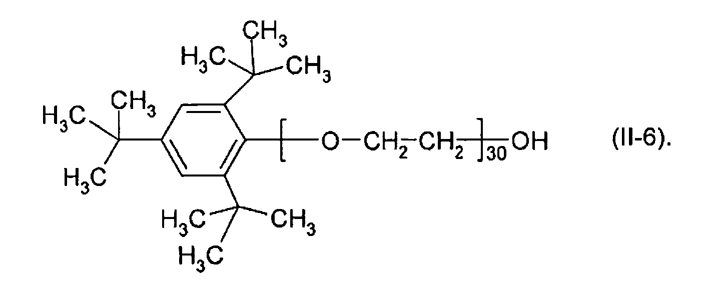

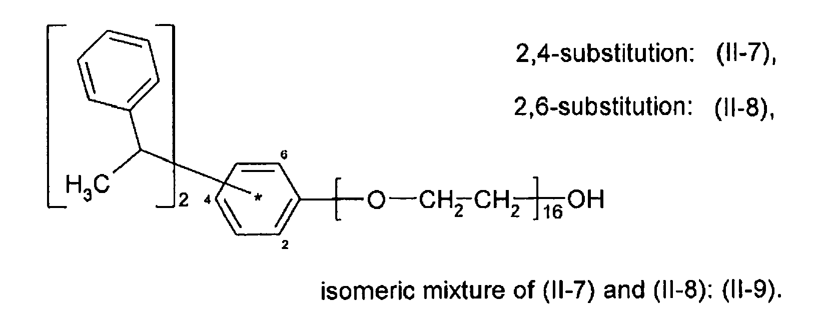

The surfactant of formula (I) can be combined with the extra surfactant in any ratio, preferably in a ratio by weight from 100 : 1 to 1 :100, but particularly when combining it with a surfactant of formula (II), the surfactant of formula (I) is advantageously used in a higher amount than the surfactant of formula (IIa). Preferred ratios by weight of the surfactant of formula (I) to the surfactant of formula (IIa) are 1 : 1 to 80 : 1, in particular from 2 : 1 to 50: 1, and most preferred from 4 : 1 to 20 : 1.

It is particularly preferred, that the developer of the present invention contains non-ionic surfactants in an amount of at least 50% by weight based on the total amount of surfactants in the developer, preferably at least 80% by weight and particular preferred at least 90% by weight. Most preferred the developer of the present invention contains solely surfactants of the non-ionic type.

The overall amount of all surfactants used in the developer preferably ranges from 0.15 to 18.0 wt.-%, 0.30 to 9.0 wt.% being particularly preferred, wherein the wt.% are based in each case on the total weight of the developer.

The developer of the present invention usually has an electric conductivity of 10 to 50 mS/cm, 20 to 40 mS/cm being preferred.

The developer according to the present invention preferably contains further components, that are selected as known in the art depending on the type of the recording materials to be developed. Particular preferred components used for the developer of the present invention are chelating agents and/or dispersants/emulsifiers and/or other additives like solubilizers e. g. aliphatic or aromatic alcohols, antifoaming agents, coloring dyes, oxidation stabilizers and others.

The chelating agents used for the developer of the present invention are selected from low molecular and/or polymeric compounds. According to the definition of W. L. Howard and D. Wilson, Kirk-Othmer Encyclopedia of Chemical Technology 2003 (online posting date July 18, 2003, a chelating agent, or chelant, contains two or more electron donor atoms that can form coordinate bonds to a single metal atom. Preferred chelating agents are selected from phosphorus containing compounds like phosphates, phosphonates or aminophosphonates, hydroxycarboxylates, aminocarboxylates, diketones, polyamines, aminoalcohols, oximes, Schiff bases, sulfur containing compounds, aromatic compounds like phenols, aminophenols, aromatic heterocyclic compounds like pyridines, pyrrols or phenanthrolines, ether compounds like macrocylic crown ethers or cryptates. Basicly the electron donating functionalities are incorporated in organic molecules. The molecular weight of these compounds can range from typical values for single organic compounds to materials of oligomeric or polymeric structure. Examples of such materials are e. g. alkali or ammonium salts of di- or triphosphoric acid, of metaphosphoric acid, of hydroxyethylene diphosphonic acid, of amino tri(methylenephosphonic acid), of ethylenediaminetetra(methylenephosphonic acid), of diethylenetriaminepenta(methylenephosphonic acid), of tartaric acid, of citric acid, of gluconic acid, of 5-sulfosalicyclic acid, of dicarboxyinulin, of ethylenediaminetetraacetic acid, of hydroxyethylethylenediaminetriacetic acid, of nitrilotriacetic acid, of n-dihydroxyethylglycine, of ethylenebis(hydroxyphenylglycine), of methylglycintriacetic acid, of N-(1,2-dicarboxyethyl)aspartic acid, of poly(aspartic acid) derivatives, of poly(p-vinylbenzyliminodiacetic acid), acetylacetone, trifluoroacetylacetone, thenoyltrifluoracetone, ethylenediamine, diethylenetriamine, triethylenetetramine, triaminotriethylamine, polyethyleneimines, triethanolamine, diethanolamine, monoethanolamine, N-alkylated ethanolamines, 2-amino-1-butanol, 2-amino-2-methyl-1,3-propanediol, 2-amino-2-methyl-1-propanol, 2-amino-2-ethyl-1,3-propanediol, 2-amino-2-methyl-1-propanol, n-hydroxyethylethylenediamine, tris(hydroxymethyl)aminomethan, dimethylglyoxime, salicylaldoxime, disalicylaldehyde, 1,2-propylenediamine, toluenedithiol, dimercaptopropanol, alkali or ammonium salts of thioglycolic acid, ethyl xanthogenic acid, diethylcarbamic acid, diethyl dithiophosphoric acid, thiurea, dithione, salicylaldehyde, disulfopyrocatechol, chromotropic acid, oxine, 8-hydroxyquinoline, alkali or ammonium salts of oxinesulfonic acid, tetraphenylporphin, phthalocyanine, dipyridyl, o-phenanthroline, dibenzo-[18]-crown-6, 2,2,2-cryptate. In a highly preferred embodiment of the present invention the chelating agent is selected from gluconic acid, an alkali metal, alkaline earth metal or ammonium salt of gluconic acid, or the *delta-*lactone of gluconic acid. The gluconic acid complexing agents have the further advantage that they are particularly environmentally friendly (they are even used in foods) and readily biodegradable. Furthermore aminoalcohols, like triethanolamine and/or tris(hydroxymethyl)aminomethane are highly preferred. The amount of the chelating agents is in general from 0.05 to 10 % by weight, preferably from 0.1 to 5 % by weight, based in each case on the total weight of the developer.

The developer of the present invention can also contain an N-alkoxylated, mono- or polyvalent amine, but it is highly preferred, that the developer is essentially free from said N-alkoxylated, mono- or or polyvalent amines. By essentially free is meant less than 2 % by weight (wt.-%), in particular less then 1 wt.-%, based on the total weight of the concentrate.

The dispersant preferably used for the developer of the present invention can be selected from a material, which is readily soluble in water having anchoring groups for the interaction with other compounds. The term dispersant is used according to the definition of R. Heusch and K. Reizlein, Ullmann's Encyclopedia of Industrial Chemistry 2002. (online posting dated June 15, 2000). According to this publication dispersants are products or mixtures of products that can promote the formation of a dispersion or stabilize a dispersion. The term dispersion is applied to a system of several phases in which one is continuous and at least one other is finely distributed therein. Dispersants are usually of oligomeric or polymeric structure. The dispersant preferably is selected from polyphosphates, ligninsulfonic acids, formaldehyde condensation products, the latter in particular with aromatic compounds, and protein condensation products. Preferred dispersants are water soluble polymers like poly(ethyleneoxide) polymers or ethyleneoxide copolymers, poly(vinylether) or vinylether copolymers, poly(ethyleneimines) or ethyleneimine copolymers, poly(acrylic(methacrylic)acid) or acrylic(methacrylic) acid copolymers, poly(maleic acid) or maleic acid copolymers, poly(amino acids) or amino acid copolymers, polysaccharides or modified polysaccharides, poly(acrylamide) or acrylamide copolymers, poly(vinylalcohols) or vinylalcohol copolymers, poly(vinylpyrrolidone) or vinylpyrrolidone copolymers. Also suitable are polymers or copolymers with attached groups, which easily can be ionized. Examples of such groups are carboxylic, sulfate, sulfonate or phosphonate anions or amino, amido or heterocyclic amino cations. Anions and cations can be existing in one polymer (polybetaines). In case of copolymers the distribution of the different units can be random or blockwise.
An emulsion is also a disperse system consisting of two (or more) mutually insoluble or sparingly soluble liquids (see R. Heusch, Emulsions in Ullmann's Encyclopedia of Industrial Chemistry 2002, online posting date: June 15, 2000). According to this agents used for the preparation of emulsions are termed emulsifiers. Emulsifiers are usually selected from the group of surfactants, preferably from those of the present invention, from the polymers as disclosed for the dispersant of the present invention, and from solid particles. Examples of such solid particles include various types of clays, activated carbon or solidified fats.

The amount of dispersant and/or emulsifier is in general from 0 to 10 % by weight, preferably from 0 to 5 % by weight, based in each case on the total weight of the developer.

Other additives e. g. solubilizers, antifoaming agents, coloring dyes, oxidation stabilizers and others can also be present. The concentration ranges according to the desirable effect between 0 and 10 % by weight, preferably from 0.01 to 5 % by weight, based in each case on the total weight of developer.

The developer of the present invention is preferably prepared in a ready-to-use concentration, but it also can be prepared as a concentrate, which has to be diluted with water to be used in the method of the present invention.

In the method of the present invention, the developer can be used batch wise, but preferably the developer is used for long production runs and is replenished with a replenisher to maintain its reactivity and performance. During these long production runs plates are usually not processed in a continuous manner. Therefore the developer is not only changed in its activity by the number of processed plates, but also during stand by times by exposition to air mainly caused by carbonisation. In order to compensate these processes it is advantageous to add replenisher independently from each other according to the number of processed plates and time used for stand by periods. The replenisher used in the method of the present invention is hereinafter also called the replenisher of the present invention.

The developer and the replenisher of the present invention can be provided in all known packaging.

The replenisher of the present invention preferably differs from the developer in that the ready to use concentration therein of the at least one inorganic salt having an alkaline reaction in water is from 1.05 to 5.0 fold, preferably from 1.1 to 3.0 fold, higher and also the concentrations of the other components preferably differ from those of the developer by a factor from 1.0 to 5.0, in particular from 1.0 to 2.0 or that there is additionally at least one inorganic salt having an alkaline reaction in water. Extra inorganic salts having an alkaline reaction in water, are preferably selected from the group consisting of an alkali metal hydroxide, an alkaline earth metal hydroxide or an ammonium hydroxide, in particular LiOH, KOH or NaOH, or an alkali metal, alkaline earth metal or ammonium salt of an inorganic or organic acid, in particular sodium dihydrogen phosphate or potassium dihydrogen phosphate, disodium hydrogen phosphate or dipotassium hydrogen phosphate, sodium borate, disodium or dipotassium carbonate, sodium or potassium hydrogencarbonate (bicarbonate). The amount of the extra inorganic salt or salts having an alkaline reaction in water can range from 0 to 15% by weight, preferably from 0 to 8% by weight and most preferred from 0.1 to 6% by weight, based in each case on the total weight of the replenisher. The replenisher is preferably prepared in a ready to use concentration, but can also be diluted with water from a replenisher concentrate. The replenisher is added to a partly spent developer in order to restore its full activity.

The method according to the invention is suitable for most of the negative-working UV/VIS sensitive recording materials on the market, in particular for those whose reproduction layer is also provided with one or more water-soluble or water-dispersible top coats. These plates are often pre heated prior to development and a water soluble top coat can also be washed off in a seperate step before processing. A sizeable advantage of the developer according to the invention is its particularly high developing capacity. The consumption of developer per square meter of recording material thus decreases substantially, so that the developer has to be replenished less frequently. The number of developer changes can be reduced, depending on the addition of replenisher. The stoppage of production is thus avoided and the work involved is also reduced. Furthermore, the developing apparatuses can be cleaned by simply washing out with water. Special cleaning agents are no longer required, what saves costs and prevents environmental pollution, as the cleaning agents used to date for this purpose are as a rule dangerous, environmentally harmful and expensive. As deposits onto the developed plates are not observed when using the developer of the present invention, it is therefore also no longer necessary to provide special filters or other apparatuses for separating off solid components in the developing machines.

The method according to the invention can be used in all known developing apparatuses, for example in emulsion bath machines, flat table machines having rotating or oscillating brushes or (high-pressure) spray developing machines. On the other hand, it was frequently required to date to use special developing apparatuses in which the brushes are encapsulated or completely surrounded by developer in order to avoid undesired foam formation. In addition, it was often necessary to lay the feed lines for the developer under the liquid level, to keep the developer in a special forced circulation or to provide the developing zone with a special cover. Developing machines usually contain other sections, e. g. compartments for pre heating plates, for washing off water soluble top coats, for rinsing processed plates for application of a gum, for post irradiation and others.

With the developer according to the invention, it is possible to develop a multiplicity of imagewise exposed reproduction layers. These layers can contain, as radiation-sensitive components, diazonium salt polycondensates or combinations of polymerizable, ethylenically unsaturated monomers and photopolymerization initiators. In addition, polymeric binders, plasticizers, sensitizer dyes, other dyes or pigments, control substances, irradiation indicators, surfactants and/or wetting agents may be added. The radiation sensitive layers to be processed according to the method of the present invention are sensitive to light in the wavelength range from 300 to 700 nm.

Particularly suitable binders in radiation-sensitive layers are polymers which are insoluble in water but soluble or at least swellable in organic solvents and in aqueous alkaline solutions. Polymers having pendant carboxyl groups are particularly suitable, for example copolymers having units of (meth)acrylic acid, crotonic acid or maleic monoesters or polymers having hydroxyl groups, some or all of which have been reacted with cyclic dicarboxylic anhydrides. The polymeric binders generally have a molecular weight M_{w} of from 500 to 1,000,000, in particular from 1000 to 200,000, and an acid number of from 10 to 250, preferably from 20 to 200. Preferred binders are copolymers (mixed polymers) of (meth)acrylic acid, of crotonic acid or of vinylacetic acid. The comonomers are in particular alkyl(meth)acrylates, hydroxyalkyl (meth)acrylates, allyl (meth)acrylates, aryl (meth)acrylates and/or (meth)acrylonitrile. Copolymers of maleic anhydride and unsubstituted or substituted styrenes, unsaturated hydrocarbons, unsaturated ethers or esters may also be mentioned. The anhydride groups contained therein may also be esterified. The amount of the binders in the radiation-sensitive mixture is in general from 10 to 90% by weight, preferably from 15 to 60 % by weight.

The monomers in the photopolymerizable mixtures are in general ethylenically unsaturated compounds, in particular acrylic or methacrylic esters of dihydric or polyhydric alcohols. Ethylene glycol di(meth)acrylate, diethylene glycol di(meth)acrylate, (meth)acrylates of trimethylolethane, trimethylolpropane, pentaerythritol, dipentaerythritol and of polyhydric alicyclic alcohols may be mentioned specifically. The reaction products of mono- or diisocyanates with partial esters of polyhydric alcohols can also advantageously be used. Finally, polymerizable compounds which additionally contain photooxidizable groups, if required also urethane groups, are also suitable. The photooxidizable groups are in general amino, urea or thio groups which may also be part of heterocyclic rings. Especially suitable photooxidizable groups are triethanolamino, triphenylamino, thiourea, imidazole, oxazole, thiazole, acetylacetonyl, N-phenylglycine and ascorbic acid groups. Among these, the polymerizable compounds having primary or secondary but in particular tertiary amino groups are preferred.

The photoinitiators can be selected from a number of classes of substances. In particular, derivatives of benzophenone, of acetophenone, of benzoin, of benzil, of fluorenone, of thioxanthone, of acridine or of quinazoline and of polynucleic quinones may be mentioned. Trichloromethyl-s-triazines, 2-halomethyl-5-vinyl-[1,3,4]oxadiazole derivatives, halooxazoles substituted by trichloromethyl groups and carbonyl methylene heterocycles containing trihalomethyl groups (EP-A 135 863 = US-A 4 966 828) also deserve mention. Finally, alkylbisacylphosphine oxides, alkylarylbisacylphosphine oxides, titanocenes, hexaarylbisimidazoles, ferrocenes, azidosulfonylphenylphthalimides, ketoxime ethers, and onium compounds (especially diaryliodonium, diazonium or sulfonium compounds) are also suitable.

The radiation-sensitive layer may contain, as sensitizer dyes, in particular photoreducible xanthene, fluorene, benzoxanthene, benzothioxanthene, thiazine, oxazine, coumarin, pyronine, porphyrin, acridine, azo, diazo, cyanine, merocyanine, diarylmethyl, triarylmethyl, anthraquinone, phenylenediamine, benzimidazole, fluorochrome, quinoline, tetrazole, naphthol, benzidine, rhodamine, indigo and/or indanthrene dyes. Also suitable are optical brighteners. The amount of the sensitizer dyes is in general from 0.01 to 15%, preferably from 0.05 to 5% by weight, based in each case on the total weight of the nonvolatile components of the radiation-sensitive layer.

In order to increase the photosensitivity further, the layer may additionally contain coinitiators. For example, the combination of titanocenes and trichloromethyl-s-triazines, of titanocenes and ketoxime ethers and of acridines and trichloromethyl-s-triazines is known. A further increase in sensitivity can be achieved by adding dibenzalacetone or amino acid derivatives. The amount of the initiator or initiators or coinitiator or coinitiators is in general from 0.01 to 20% by weight, preferably from 0.05 to 10% by weight, based in each case on the total weight of the nonvolatile components of the radiation-sensitive layer.

Dyes or pigments may be added for colouring the radiation-sensitive layer. In general, phthalocyanine, rhodamine, triarylmethane, azo, diazo, anthraquinone, naphthol or phenylenediamine dyes or inorganic coloured pigments are used for this purpose.

In order to establish specific properties, inhibitors and control substances may furthermore be present in the layer. These include benzophenone compounds, phosphorus compounds, cycloacetals, quinones, quinolines, naphthoquinones, anthraquinones, ethers, sterically hindered amines, benzothiazols, thiurams, thiocarbamates, phenols, naphthols, benzimidazoles, mercaptobenzimidazoles and phenylenediamines. The amount of the inhibitors and/or control substances is in general from 0.001 to 10% by weight, preferably from 0.005 to 5% by weight, based in each case on the total weight of the nonvolatile components of the radiation-sensitive layer.

Any topcoats present in the recording materials essentially comprise water-soluble or water-emulsifiable polymeric binders. They may also contain wetting agents, adhesion promoters, antifoams, dyes and other assistants. Such topcoats are likewise known to those skilled in the art.

The layer support in the lithographic printing plates to be processed according to the method of the present invention preferably consists of metal, in particular of aluminum, steel, zinc, copper or metal alloys, plastic, in particular polyethylene terephthalate (PET), cellulose acetate or polyamide (PA).

The surface of the supports is in many cases pretreated. Thus, aluminum supports are frequently mechanically and/or chemically and/or electrochemically roughened, anodically oxidized and/or hydrophilized. Such pretreatments result in the reproduction layer adhering better thereon, so that lithographic properties of the support - in particular its water acceptance and water retentivity - are improved or so that the support reflects to a lesser extent during the imagewise exposure (antihalation). The same effect can be achieved by applying to the support special layers which comprise, for example, binders, pigments and, if required, additives.

The radiation-sensitive recording materials are prepared by processes which are known per se to the person skilled in the art. In general, the components of the radiation-sensitive layer are dissolved or dispersed in an organic solvent or solvent mixture, the solution or dispersion is applied to the intended support by pouring on, spraying on, emersion, roll application or in a similar manner and the solvents are removed during the subsequent drying.

Imagewise exposure is affected using coherent light of a laser or UV or VIS laser diodes. Lasers of suitable power, for example argon ion lasers, crypton ion lasers, dye lasers, solid-state lasers, helium-cadmium lasers, helium-neon lasers and laser diodes, which emit between 300 and 700 nm, particularly between 350 and 600 nm, are suitable. The laser beam can be controlled by a specified program and the exposure can be performed by movements along the lines and along the grid.

The invention is illustrated in more detail by the following examples without limiting it thereto. Unless stated otherwise, parts by weight (p.b.w.) and parts by volume (p.b.v.) bear the same relation as that of g to ml. Percentages and ratios are to be understood as weight units.

Further preferred embodiments of the present invention are disclosed in the dependent claims.

### EXAMPLES

### Comparative example 1

A dip tank lab processor equipped with integrated pre heat and overcoat wash off section was filled with 4100 g of a developer containing the following ingredients:

| | |
|---|---|
| 5.00 p.b.w. | Surfactant (I-1) |
| 3.06 p.b.w. | potassium silicate solution containing 21.0-22.0 % K₂O, 19.5 - 20.5 % SiO₂ and 57.5 - 59.5 % water |
| 0.11 p.b.w. | Trilon B^{®} (Tetra-Na salt of EDTA, 87 %) |
| 91.83 p.b.w. | deionized water |

The resulting developer had a pH of 12.5 and a conductivity of 14.3 mS/cm. The operating temperature was 25.8 +/- 0.7 °C. Over a period of 2 days the developer was saturated with 60 m² of non imaged violet sensitive N91v^{®} plates. After 10 m² each a plate carrying different common test elements imaged with a Polaris X^{®} equipped with violet laser diode was processed and evaluated. At the same time the developer was characterized by measuring temperature, pH, conductivity and turbidity.

Over the whole process stable values for sensitivity, dot gain and background stain could be observed. At the end of the test the developer was removed and a nearly clean processor was obtained, which was easily to prepare for the next run by rinsing with plain water.

The sedimentation of the exhausted developer was evaluated by taking two samples of about 50 g each and centrifugation at 6000 rpm for 30 minutes. The obtained sediment was decanted over 1 minute, dried in a circulation oven at 100 °C for 45 minutes and equilibrated in an exsiccator over silica gel within 1 hour. Finally 3.90 +/- 0.02 g solid per kg developer was isolated.

### Example 1

A dip tank lab processor equipped with integrated pre heat and overcoat wash off section was filled with 4100 g of a developer containing the following ingredients:

| | |
|---|---|
| 5.00 p. b. w. | Surfactant (I-1) |
| 0.30 p. b. w. | Surfactant (II-1) |
| 6.12 p. b. w. | potassium silicate solution containing 21.0-22.0 % K₂O, 19.5 - 20.5 % SiO₂ and 57.5 - 59.5 % water |
| 0.75 p. b. w. | sodium gluconate |
| 87.83 p. b. w. | deionized water |

The resulting developer had a pH of 12.9 and a conductivity of 25.9 mS/cm. The operating temperature was 25.4 +/- 0.2 °C. Over a period of 2 days the developer was saturated with 60 m² of non imaged green sensitive N91^{®} plates. After 10 m² each a plate carrying different common test elements imaged with a Polaris 100^{®} equipped with FdYAG laser was processed and evaluated. At the same time the developer was characterized by measuring temperature, pH, conductivity and turbidity.

Over the whole process stable values for sensitivity, dot gain and background stain could be observed. At the end of the test the developer was removed and an an almost clean processor was obtained, which was easily to prepare for the next run by rinsing with plain water.

The sedimentation tendency of the exhausted developer was evaluated by taking two samples of about 50 g each and centrifugation at 6000 rpm for 30 minutes. The obtained sediment was decanted over 1 minute, dried in a circulation oven at 100 °C for 45 minutes and equilibrated in an exsiccator over silica gel within 1 hour. Finally 3.70 +/- 0.01 g solid per kg developer was isolated.

### Comparative example 2

The procedure described under comparative example 1 was repeated, but a commercially available photopolymer developer EN 231C^{®} was used under the same conditions. After removal of the exhausted developer the processor looked slightly more contaminated. Rinsing with plain water did not completely remove this contamination. The sedimentation test as used in example 1 gave a sludge value of 10,9 +/- 0.05 g per kg developer.

From example 1 and comparative examples 1 and 2 it can clearly be seen, that a developer of the present invention comprising a surfactant of formula (I) results in much less sediment when used to develop a violet or green sensitive printing plate precursor than a developer according to the prior art.

### comparative examples 3-14

A stock solution was prepared as follows:

| | | |
|---|---|---|
| 88.08 | p. b. w. | deionized water |
| 6.12 | p. b. w. | potassium silicate solution containing 21.0-22.0 % K₂O, 19.5 - 20.5 % SiO₂ and 57.5 - 59.5 % water |
| 0.80 | p. b. w. | sodium gluconate |

To 95.0 p. b. w. of this solution the EO/PO-surfactants were added according to table 1.

**Table 1**

| **No.** | **Surfactant p.b.w.** |
|---|---|
| Comparative Example 3 | 5.00 Surfactant (I-2) |
| Comparative Example 4 | 5.00 Surfactant (I-3) |
| Comparative Example 5 | 5.00 Surfactant (I-4) |
| Comparative Example 6 | 5.00 Surfactant (I-1) |
| Comparative Example 7 | 5.00 Surfactant (1-5) |
| Comparative example 8 | 5.00 Pluronic PE 6400^{®} (MW (PO) ~ 1750 / 40 % EO) |
| Comparative example 9 | 5.00 Symperonic T/304^{®} (MW (PO) ~ -24 EO) |
| Comparative example 10 | 5.00 Symperonic T/908^{®} (MW (PO) ~ -21 EO) |
| Comparative example 11 | 5.00 Pluronic RPE 1740^{®} ((MW (PO) ∼ -20 EO) |
| Comparative example 12 | 5.00 Polyglycol P41/300^{®} (statistical / MW ~ 3500) |
| Comparative example 13 | 5.00 Polyglycol B 11/150^{®} (statistical / MW ~ 3100) |
| Comparative example 14 | 5.00 Polyglycol PR 300^{®} (block / MW ~ 300) |

A 40 x 15 cm sized N91v^{®} plate imaged with different test elements was preheated and the overcoat was washed off. Then the plate is processed manually in 50

ml of the above described developer solutions at 22°C within 30 s giving for all examples a clean printing plate of comparable sensitivity. The resulting used developers have been stored at room temperature for 7 days. The sedimentation stability was measured by comparing the turbidity values of the unmoved solutions after 4 hours, 1 day, 3 days and 7 days. The obtained values have been averaged (AV) and the standard deviation was calculated (SD). The turbidity is given in relative turbidity units (TU) versus formazine (F) that is used as a standard. After 7 days each sample was centrifugated at 6000 rpm for 30 minutes. The obtained sediment was decanted over 1 minute, dried in a circulation oven at 100 °C for 45 minutes and equilibrated in an exsiccator over silica gel within 1 hour. The results for the different developers are summarized in table 2, and show the surprising advantage in respect to over all solution turbidity (AV), solution stability (SD) and significant lower tendency for sedimentation, that can only be achieved by using the specific EO/PO block copolymer surfactants of the present invention.

**Table 2: Characteristic data, turbidity values and isolated sediment**

| **No.** | **pH** | **Conductivity** [mS/cm] | **AV turbidity** [TU/F] | **SD turbidity** [TU/F] | **Sediment** [g/kg] |
|---|---|---|---|---|---|
| Comparative Example 3 | 12.9 | 27.6 | 324 | 21.5 | 0.48 |
| Comparative Example 4 | 12.9 | 28.1 | 309 | 13.7 | 0.38 |
| Comparative Example 5 | 12,9 | 28,1 | 335 | 11.0 | 0.53 |
| ComparativeExample 6 | 12,9 | 27,5 | 368 | 38.1 | 0.41 |
| Comparative Example 7 | 12,9 | 27,9 | 358 | 19.0 | 0.45 |
| Comparative example 8 | 12.9 | 26.6 | 701 | 195.5 | 0.92 |
| Comparative example 9 | 12.9 | 26.6 | 719 | 155.7 | 0.75 |
| Comparative example 10 | 12.9 | 26.7 | 441 | 42.7 | 2.12 |
| Comparative example 11 | 12.9 | 26.4 | 772 | 214.6 | 0.96 |
| Comparative example 12 | 12.9 | 26.6 | 859 | 128.4 | 1.31 |
| Comparative example 13 | 12.9 | 26.4 | 893 | 119.1 | 1.08 |
| Comparative example 14 | 12.8 | 26.8 | 802 | 128.6 | 0.71 |

### Examples 2-4 and comparative example 15

The same procedure as described under "comparative examples 3-14" was used, but a stock solution was prepared as follows:

| | | |
|---|---|---|
| 86.93 | p. b. w. | deionized water |
| 5.00 | p. b. w. | Compound I-1 |
| 6.12 | p. b. w. | potassium silicate solution containing 21.0-22.0 wt-% K₂O, 19.5-20.5 wt-% SiO₂ and 57.5-59.5 wt-% water |
| 0.75 | p. b. w. | sodium gluconate |

To 98.8 p. b. w. of this solution different amounts of compound II-1 and water were added according to table 3.

**Table 3: Type and amounts of additions**

| **No.** | **Cosurfactant p.b.w.** | **Water p.b.w.** |
|---|---|---|
| Comparative Example 15 | none | 1.20 |
| Example 2 | 0.30 Compound II-1 | 0.90 |
| Example 13 | 0.60 Compound II-1 | 0.60 |
| Example 14 | 0.90 Compound II-1 | 0.30 |

The results for the different developers are summarized in table 4 and demonstrate the synergistic effect when using a surfactant of formula (I) and a surfactant of formula (IIa) in combination.

**Table 4: Characteristic data, turbidity values and isolated sediment**

| **No.** | **pH** | **Conductivity** [mS/cm] | **AV turbidity** [TU/F] | **SD turbidity** [TU/F] | **Sediment** [g/kg] |
|---|---|---|---|---|---|
| Comparative Example 15 | 12.9 | 27.2 | 351 | 27.6 | 0.46 |
| Example 2. | 12.9 | 27.3 | 371 | 20.8 | 0.45 |
| Example 3 | 12,9 | 27,3 | 370 | 20.1 | 0.42 |
| Example 4 | 12.9 | 27.2 | 345 | 18.0 | 0.40 |

### Examples 5 and comparative examples 16-20

The same procedure as described under "comparative examples 3-14" was used, but a stock solution was prepared as follows:

| | | |
|---|---|---|
| 5.0 | p. b. w. | Compound I-1, |
| 3.06 | p. b. w. | potassium silicate solution containing 21.0-22.0 wt-% K₂O, 19.5-20.5 wt-% SiO₂ and 57.5-59.5 wt-% water |
| 0.12 | p. b. w. | Trilon B^{®} (Tetra-Na salt of EDTA, 87 %) |
| 91.52 | p. b. w. | deionized water |

To 99.7 p. b. w. of this solution different surfactants and water were added according to table 5.

**Table 5: Type and amounts of additions**

| **No.** | **Cosurfactant p.b.w.** |
|---|---|
| Example 5 | 0.30 Compound II-1 |
| Comparative Example 16 | 0.30 Rewopal MPG 40^{®} (Phenol-EO₄-H) |
| Comparative Example 17 | 0.30 Solsperse 27000^{®} (Naphthol-EOn-H) |
| Comparative Example 18 | 0.30 Genapol C 200^{®} (Coconut fatty alcohol-EO₂₀-H) |
| Comparative Example 19 | 0.30 Metolat FC 355^{®} (Ethylenedianmine-4xEO₁₁-H) |
| Comparative Example 20 | 0.30 Emulsogen EPA 073^{®} (Na-Alkylethersulfate-EO₇-H) |

The results for the different developers are summarized in table 6 and demonstrate, that the synergistic effect of surfactants of formula (I) with surfactants of formula (IIa).

**Table 6: pH, turbidity values and isolated sediment**

| **No.** | **pH** | **AV turbidity** [TU/F] | **SD turbidity** [TU/F] | **Sediment** [g/kg] |
|---|---|---|---|---|
| Example 5 | 12.8 | 438 | 21.0 | 0.46 |
| Comparative Example 16 | 12.6 | 501 | 107.3 | 0.67 |
| Example 17 | 12,6 | 529 | 110.2 | 0.61 |
| Example 18 | 12.6 | 447 | 24.6 | 0.60 |
| Example 19 | 12,6 | 547 | 202.1 | 0.64 |
| Example 20 | 12,6 | 485 | 42.2 | 0.63 |

## Claims

1. A method of making a lithographic printing plate comprising the steps of providing a photopolymer printing plate precursor that is photopolymerizable upon absorption of light in the wavelength range from 300 to 700 nm, exposing said printing plate precursor with laser light in the range from 300 to 700 nm and processing said exposed precursor with an aqueous alkaline developer, **characterized in that** the alkaline developer comprises a surfactant of formula (I) 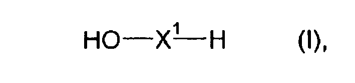 wherein
X¹ consists of Z¹ and Z² blocks and comprises at least one Z¹ and at least one Z² block,
Z¹ represents -(-CH₂-CH₂-O-)ₓ- ,
Z² represents -(-CH₂-CH(CH3)-O-)_{y}-, and wherein
x, y mean mutually independent integers and are selected such that the surfactant of formula (I) has a total molecular weight of the Z² block(s) of at least 2000 g/mol and comprises 25 to 55 weight-% of the Z¹ block(s), wherein the weight-% of the Z¹ block(s) is based on the total molecular weight of the Z¹ blocks and the Z² blocks in the molecule,
and a surfactant of Formula IIa, 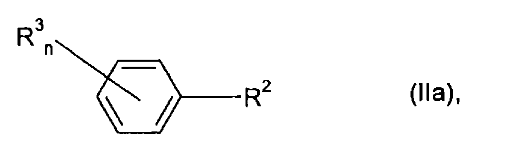 wherein
R² represents a hydrophilic group comprising a polyethyleneoxy group with at least 6 ethyleneoxy units,
R³ represents a 1,1-phenylethyl or a t-butyl group, and
n means 2 or 3.

2. A method according to claim 1, wherein x, y are selected such that the surfactant of formula (I) has a total molecular weight of the Z² block(s) in the range from 2200 to 6000 g/mol.

3. A method according to any of the preceding claims, wherein x, y are selected such that the surfactant of formula (I) comprises 30 to 50 weight-% of the Z¹ block(s) based on the total molecular weight of the Z¹ blocks and the Z² blocks in the molecule.

4. A method according to any of the preceding claims, wherein X¹ means -Z¹-Z²-, -Z²-Z¹-, -Z¹-Z²-Z¹- or -Z²-Z¹-Z²-.

5. A method according to any of the preceding claims, wherein the alkaline developer is based on water and comprises at least one alkaline reacting silicate, and wherein the developer has a pH of at least 11.

6. A method according to claim 5, wherein the concentration of the silicate is at least 0.2 weight-% based on the total weight of the developer.

7. A method according to any of the preceding claims, wherein the concentration of the surfactant of formula (I) is at least 0.05 weight-% based on the total weight of the developer.

8. A method according to any of the preceding claims, wherein the developer solution has a pH in the range from 11.5 to 14.

9. A method according to any of the preceding claims wherein the ratio by weight of the surfactant of formula (I) to the surfactant of formula (IIa) is from 1 : 1 to 80 : 1.

10. A method according to any of the preceding claims, wherein the developer is replenished with a replenisher.

## Patentansprüche

1. Ein Verfahren zur Herstellung einer lithografischen Druckplatte, das folgende Schritte umfasst : Bereitstellen einer Vorstufe einer Fotopolymer-Druckplatte, die bei Absorption von Licht im Wellenlängenbereich zwischen 300 und 700 nm fotopolymerisierbar ist, Belichtung der Druckplattenvorstufe mit Laserlicht im Wellenlängenbereich zwischen 300 und 700 nm und Entwicklung der belichteten Vorstufe mit einem wässrig-alkalischen Entwickler, **dadurch gekennzeichnet, dass** der alkalische Entwickler ein Tensid der folgenden Formel (I) : 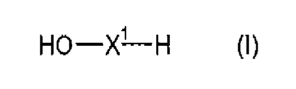 in der :
X¹ aus Z¹-Blöcken und Z²-Blöcken zusammengesetzt ist und mindestens einen Z¹-Block und mindestens einen Z²-Block umfasst,
Z¹ -(-CH₂-CH₂-O-)ₓ- bedeutet,
Z² -(-CH₂-CH(CH₃)-O-)_{y}- bedeutet und
x und y unabhängig voneinander jeweils eine ganze Zahl bedeuten und so gewählt werden, dass das Tensid der Formel (I) den Z²-Block bzw. die Z²-Blöcke in einem Gesamtmolekulargewicht von mindestens 2.000 g/Mol enthält und den Z¹-Block bzw. die Z¹-Blöcke in einem Verhältnis zwischen 25 und 55 Gew.-%, bezogen auf das Gesamtmolekulargewicht der Z¹-Blöcke und der Z²-Blöcke im Molekül, enthält,
und ein Tensid der folgenden Formel IIa enthält, 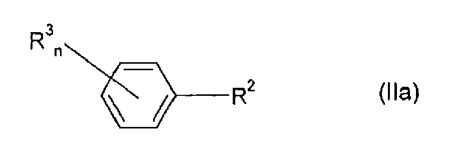 in der :
R² eine hydrophile Gruppe, die eine Polyethylenoxygruppe mit mindestens 6 Ethylenoxyeinheiten umfasst, bedeutet,
R³ eine 1,1-Phenylethylgruppe oder eine t-Butylgruppe bedeutet und
n 2 oder 3 bedeutet.

2. Verfahren nach Anspruch 1, **dadurch gekennzeichnet, dass** x und y so gewählt werden, dass das Tensid der Formel (I) ein Gesamtmolekulargewicht des Z²-Blocks bzw. der Z²-Blöcke zwischen 2.200 und 6.000 g/Mol aufweist.

3. Verfahren nach einem der vorstehenden Ansprüche, **dadurch gekennzeichnet, dass** x und y so gewählt werden, dass das Tensid der Formel (I) den Z¹-Block bzw. die Z¹-Blöcke in einem Verhältnis zwischen 30 und 50 Gew.-%, bezogen auf das Gesamtmolekulargewicht der Z¹-Blöcke und der Z²-Blöcke im Molekül, enthält.

4. Verfahren nach einem der vorstehenden Ansprüche, **dadurch gekennzeichnet, dass** X¹ -Z¹-Z²-, -Z²-Z¹-, -Z¹-Z²-Z¹- oder -Z²-Z¹-Z²- bedeutet.

5. Verfahren nach einem der vorstehenden Ansprüche, **dadurch gekennzeichnet, dass** der alkalische Entwickler ein wässriger Entwickler ist und mindestens ein reaktives alkalisches Silikat enthält und der pH-Wert des Entwicklers mindestens 11 beträgt.

6. Verfahren nach Anspruch 5, **dadurch gekennzeichnet, dass** das Verhältnis des Silikats mindestens 0,2 Gew.-%, bezogen auf das Gesamtgewicht des Entwicklers, beträgt.

7. Verfahren nach einem der vorstehenden Ansprüche, **dadurch gekennzeichnet, dass** das Verhältnis des Tensids der Formel (I) mindestens 0,05 Gew.-%, bezogen auf das Gesamtgewicht des Entwicklers, beträgt.

8. Verfahren nach einem der vorstehenden Ansprüche, **dadurch gekennzeichnet, dass** die Entwicklerlösung einen pH zwischen 11,5 und 14 aufweist.

9. Verfahren nach einem der vorstehenden Ansprüche, **dadurch gekennzeichnet, dass** das Gewichtsverhältnis des Tensids der Formel (I) zum Tensid der Formel (IIa) zwischen 1;1 und 80:1 liegt.

10. Verfahren nach einem der vorstehenden Ansprüche, **dadurch gekennzeichnet, dass** der Entwickler mit einem Regeneriermittel regeneriert wird.

## Revendications

1. Un procédé pour la confection d'une plaque d'impression lithographique, comprenant l'étape de la mise à disposition d'un précurseur d'une plaque d'impression photopolymère qui est photopolymérisable par absorption de lumière d'une longueur d'onde comprise entre 300 et 700 nm, l'étape de l'exposition du précurseur de plaque d'impression à de la lumière laser d'une longueur d'onde comprise entre 300 et 700 nm et l'étape du développement du précurseur exposé en utilisant un révélateur alcalin aqueux, **caractérisé en ce que** le révélateur alcalin contient un agent tensioactif répondant à la formule (I) : 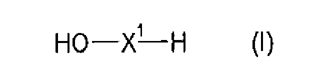 où :
X¹ est composé de blocs Z¹ et de blocs Z² et comprend au moins un bloc Z¹ et au moins un bloc Z²,
Z¹ représente -(-CH₂-CH₂-O-)ₓ-,
Z² représente -(-CH₂-CH(CH₃)-O-)_{y}- et
x et y représentent, indépendamment l'un de l'autre, un nombre entier et sont choisis de façon à ce que l'agent tensioactif répondant à la formule (I) présente un poids moléculaire total du (des) bloc(s) Z² d'au moins 2.000 g/mole et qu'il contienne entre 25 et 55% en poids du (des) bloc(s) Z¹ par rapport au poids moléculaire total des blocs Z¹ et des blocs Z² compris dans la molécule,
et un agent tensioactif répondant à la formule IIa, 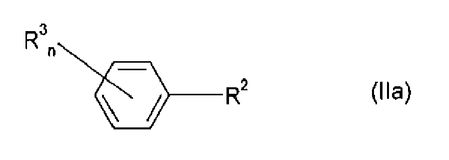 où :
R² représente un groupe hydrophile comprenant un groupe polyéthylèneoxy contenant au moins 6 unités éthylèneoxy, R³ représente un groupe 1,1-phényléthyle ou un groupe t-butyle et n représente 2 ou 3.

2. Procédé selon la revendication 1, **caractérisé en ce que** x et y sont choisis de façon à ce que l'agent tensioactif répondant à la formule (I) présente un poids moléculaire total du (des) bloc(s) Z² compris entre 2.200 et 6.000 g/mole.

3. Procédé selon l'une quelconque des revendications précédentes, **caractérisé en ce que** x et y sont choisis de façon à ce que l'agent tensioactif répondant à la formule (I) contienne entre 25 et 50% en poids du (des) bloc(s) Z¹ par rapport au poids moléculaire total des blocs Z¹ et des blocs Z² compris dans la molécule.

4. Procédé selon l'une quelconque des revendications précédentes, **caractérisé en ce que** X¹ représente -Z¹-Z²-, -Z²-Z¹-, -Z¹-Z²-Z¹- ou -Z²-Z¹-Z²-_{.}

5. Procédé selon l'une quelconque des revendications précédentes, **caractérisé en ce que** le révélateur alcalin est un révélateur aqueux contenant au moins un silicate réactif aqueux et que la valeur de pH du révélateur s'élève à au moins 11.

6. Procédé selon la revendication 5, **caractérisé en ce que** le rapport du silicate s'élève à au moins 0,2% en poids par rapport au poids total du révélateur.

7. Procédé selon l'une quelconque des revendications précédentes, **caractérisé en ce que** le rapport de l'agent tensioactif répondant à la formule (I) s'élève à au moins 0,05% en poids par rapport au poids total du révélateur.

8. Procédé selon l'une quelconque des revendications précédentes, **caractérisé en ce que** la valeur de pH de la solution révélatrice est comprise entre 11,5 et 14.

9. Procédé selon l'une quelconque des revendications précédentes, **caractérisé en ce que** le rapport pondéral de l'agent tensioactif répondant à la formule (I) à l'agent tensioactif répondant à la formule (IIa) est compris entre 1:1 et 80:1.

10. procédé selon l'une quelconque des revendications précédentes, **caractérisé en ce que** le révélateur est régénéré à l'aide d'un agent régénérateur.
